# EUROPEAN PATENT APPLICATION

(11) **EP 4 675 292 A1**
(43) Date of publication of application: **07.01.2026**
(21) Application number: 24849603.6
(22) Date of filing: 31.07.2024
(51) Int. Cl.: G01R 31/392, G01R 31/385, G01R 31/374, G01R 19/10, G01R 19/165, G01R 19/30, G01R 31/396, G01R 31/52

(54) **BATTERY DIAGNOSIS DEVICE AND OPERATION METHOD THEREOF**

(30) Priority: 02.08.2023 KR 20230101177
(71) Applicant: LG Energy Solution, Ltd., Seoul 07335 (KR)
(72) Inventor: LEE, Sun Jong, Daejeon 34122 (KR); KIM, Cheol Taek, Daejeon 34122 (KR); CHOI, Won, Daejeon 34122 (KR)
(74) Representative: Goddar, Heinz J.
(86) International application number: PCT/KR2024/011220
(87) International publication number: WO 2025/029036

(57) **Abstract**

A battery diagnosis apparatus according to an embodiment disclosed herein includes an obtaining unit configured to obtain voltage data in a rest period of a plurality of battery cells included in a battery module, a deviation calculating unit configured to calculate a voltage deviation between adjacent periods at designated time intervals from a designated point in time, in the unit of cell groups connected in parallel to each other among the plurality of battery cells, based on the voltage data, a cumulative calculating unit configured to calculate a cumulative deviation by cumulatively summing the voltage deviation in the unit of cell group, when a maximum voltage deviation among a plurality of voltage deviations of a plurality of cell groups in a target period is greater than or equal to a first threshold value, and a diagnosing unit configured to diagnose, as abnormal battery cells, battery cells included in a cell group which satisfies designated conditions among the plurality of cell groups, based on the voltage deviation and the cumulative deviation.

## Description

### [TECHNICAL FIELD]

### CROSS-REFERENCE TO RELATED APPLICATION

This application claims priority to and the benefit of Korean Patent Application No. 10-2023-0101177 filed in the Korean Intellectual Property Office on August 2, 2023.

### TECHNICAL FIELD

Embodiments disclosed herein relate to a battery diagnosis apparatus and an operating method thereof.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Furthermore, the secondary battery is generally used as a battery pack including a battery module where a plurality of battery cells are connected to one another in series and/or in parallel. The secondary battery may be used as a battery rack including a plurality of battery modules and a rack frame receiving the battery modules.

The battery cell, the battery module, the battery pack, or the battery rack may be used in various devices. For example, the batteries may be used not only for mobile devices such as mobile phones, laptop computers, smart phones, smart pads, etc., but also in the field of vehicles (electric vehicles (EV), hybrid electric vehicles (HEV), plug-in HEV (PHEV)) driven with electricity, large-volume energy storage systems (ESS), etc.

### [DISCLOSURE]

### [TECHNICAL PROBLEM]

A battery may ignite during use, and one of the most likely causes of ignition is an internal short-circuit caused by lithium precipitation on a surface of a negative electrode of the battery. In a normal battery, lithium ions from a positive electrode enter a negative electrode during charging, but in a defective battery, some lithium ions are precipitated in the form of lithium metal on a surface of the negative electrode. As the precipitated lithium continuously grows due to repetitive charging, the precipitated lithium comes into contact with the positive electrode or a positive electrode collector of the battery, such that an internal short-circuit may occur. As the internal short-circuit of the battery becomes severe, fire may occur due to thermal runaway.

Thus, there is a need for a scheme to previously detect abnormality of the battery to reduce the possibility of damage of devices including the battery.

Embodiments disclosed herein aim to provide a battery diagnosis apparatus and an operating method thereof in which lithium precipitation of the battery and/or disconnection of a negative electrode tab may be diagnosed by using a battery voltage deviation and an accumulative deviation obtained by accumulatively summing the battery voltage deviation.

Technical problems of the embodiments disclosed herein are not limited to the aforementioned technical problems, and other unmentioned technical problems would be clearly understood by those of ordinary skill in the art from the following description.

### [TECHNICAL SOLUTION]

A battery diagnosis apparatus according to an embodiment disclosed herein includes an obtaining unit configured to obtain voltage data in a rest period of a plurality of battery cells included in a battery module, a deviation calculating unit configured to calculate a voltage deviation between adjacent periods at designated time intervals from a designated point in time, in the unit of cell groups connected in parallel to each other among the plurality of battery cells, based on the voltage data, a cumulative calculating unit configured to calculate a cumulative deviation by cumulatively summing the voltage deviation in the unit of cell group, when a maximum voltage deviation among a plurality of voltage deviations of a plurality of cell groups in a target period is greater than or equal to a first threshold value, and a diagnosing unit configured to diagnose, as abnormal battery cells, battery cells included in a cell group which satisfies designated conditions among the plurality of cell groups, based on the voltage deviation and the cumulative deviation.

In the battery diagnosis apparatus according to an embodiment disclosed herein, the cumulative calculating unit may be further configured to calculate the cumulative deviation by cumulatively summing the voltage deviation for a period in which an average of a plurality of cumulative deviations of the plurality of cell groups is less than a second threshold value.

The battery diagnosis apparatus according to an embodiment disclosed herein may further include a rate calculating unit configured to calculate a first rate by dividing the cumulative deviation by a value greater between the average of the plurality of cumulative deviations and the second threshold value, in which the diagnosing unit is further configured to diagnose, abnormal battery cells, battery cells included in a cell group which satisfies the designated conditions based on the first rate.

The battery diagnosis apparatus according to an embodiment disclosed herein may further include a correcting unit configured to correct the first rate to a second rate by using an open circuit voltage (OCV) deviation with respect to a state of charge (SOC) change, in the unit of the cell group, in which the diagnosing unit is further configured to diagnose, abnormal battery cells, battery cells included in a cell group which satisfies the designated conditions based on the second rate.

In the battery diagnosis apparatus according to an embodiment disclosed herein, the correcting unit may be further configured to calculate an OCV deviation rate by dividing the OCV deviation by an average of a plurality of OCV deviations of the plurality of cell groups, in the unit of the cell group and calculate the second rate by dividing the first rate by a value greater between the OCV deviation rate and a designated value, in the unit of the cell group.

In the battery diagnosis apparatus according to an embodiment disclosed herein, the designated conditions may include a first condition in which a difference between the voltage deviation in a diagnosis period and an average of a plurality of voltage deviations of the plurality of cell groups in the diagnosis period is less than or equal to a threshold value.

In the battery diagnosis apparatus according to an embodiment disclosed herein, the designated conditions may include a second condition in which the second rate in a diagnosis period is a maximum value of a plurality of second rates of the plurality of cell groups in the diagnosis period.

In the battery diagnosis apparatus according to an embodiment disclosed herein, the designated conditions may include a third condition in which the second rate in the diagnosis period is greater than or equal to a fourth threshold value.

In the battery diagnosis apparatus according to an embodiment disclosed herein, the designated conditions may include a fourth condition in which the second rate in the diagnosis period is a maximum value among the plurality of second rates of the plurality of cell groups in the diagnosis period and a difference between the second rate in the diagnosis period and a second maximum value among the plurality of second rates is greater than or equal to a fifth threshold value.

A battery diagnosis method according to an embodiment disclosed herein includes obtaining voltage data in a rest period of a plurality of battery cells included in a battery module, calculating a voltage deviation between adjacent periods at designated time intervals from a designated point in time, in the unit of cell groups connected in parallel to each other among the plurality of battery cells, based on the voltage data, calculating a cumulative deviation by cumulatively summing the voltage deviation in the unit of cell group, when a maximum voltage deviation among a plurality of voltage deviations of a plurality of cell groups in a target period is greater than or equal to a first threshold value, and diagnosing, as abnormal battery cells, battery cells included in a cell group which satisfies designated conditions among the plurality of cell groups, based on the voltage deviation and the cumulative deviation.

In the battery diagnosis method according to an embodiment disclosed herein, the calculating of the cumulative deviation may include calculating the cumulative deviation by cumulatively summing the voltage deviation for a period in which an average of a plurality of cumulative deviations of the plurality of cell groups is less than a second threshold value.

The battery diagnosis method according to an embodiment disclosed herein may further include calculating a first rate by dividing the cumulative deviation by a value greater between the average of the plurality of cumulative deviations and the second threshold value, in which the diagnosing includes diagnosing, abnormal battery cells, battery cells included in a cell group which satisfies the designated conditions based on the first rate.

The battery diagnosis method according to an embodiment disclosed herein may further include correcting the first rate to a second rate by using an open circuit voltage (OCV) deviation with respect to a state of charge (SOC) change, in the unit of the cell group, in which the diagnosing includes diagnosing, abnormal battery cells, battery cells included in a cell group which satisfies the designated conditions based on the second rate.

The battery diagnosis method according to an embodiment disclosed herein may further include calculating an OCV deviation rate by dividing the OCV deviation by an average of a plurality of OCV deviations of the plurality of cell groups, in the unit of the cell group, in which the correcting of the first rate to the second rate includes calculating the second rate by dividing the first rate by a value greater between the OCV deviation rate and a designated value in the unit of the cell group.

In the battery diagnosis method according to an embodiment disclosed herein, the designated conditions may include a first condition in which a difference between the voltage deviation in a diagnosis period and an average of a plurality of voltage deviations of the plurality of cell groups in the diagnosis period is less than or equal to a threshold value, a second condition in which the second rate in a diagnosis period is a maximum value of a plurality of second rates of the plurality of cell groups in the diagnosis period, a third condition in which the second rate in the diagnosis period is greater than or equal to a fourth threshold value, or a fourth condition in which the second rate in the diagnosis period is a maximum value among the plurality of second rates of the plurality of cell groups in the diagnosis period and a difference between the second rate in the diagnosis period and a second maximum value among the plurality of second rates is greater than or equal to a fifth threshold value.

### [ADVANTAGEOUS EFFECTS]

According to embodiments disclosed herein, by diagnosing a battery having negative electrode tab disconnection occurred and/or a battery having negative electrode tab disconnection and lithium precipitation occurred, the battery likely to lead to an internal short-circuit later may be traced and managed.

In addition, various effects identified directly or indirectly through this document may be provided.

### [DESCRIPTION OF DRAWINGS]

FIG. 1 is a block diagram of a battery diagnosis apparatus according to an embodiment.
FIG. 2 is a block diagram of a calculating unit in a battery diagnosis apparatus according to an embodiment.
FIG. 3 shows a rest period voltage obtained by a battery diagnosis apparatus according to an embodiment.
FIG. 4 shows a voltage deviation calculated by a battery diagnosis apparatus according to an embodiment.
FIG. 5 shows an accumulative deviation calculated by a battery diagnosis apparatus according to an embodiment.
FIG. 6 shows a second rate calculated by a battery diagnosis apparatus according to an embodiment.
FIG. 7 is an operation flowchart of a battery diagnosis apparatus according to an embodiment.
FIG. 8 is an operation flowchart of a battery diagnosis apparatus according to an embodiment.
FIG. 9 is an operation flowchart of a battery diagnosis apparatus according to an embodiment.

### [MODE FOR INVENTION]

Hereinafter, various embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly), wirelessly, or via a third element).

According to various embodiments of the disclosure, each of the above-described components (e.g., a module or program) may include a single entity or a plurality of entities, some of which may be separately disposed on other components. According to various embodiments of the disclosure, one or more of the above-described components or operations may be omitted or one or more other components or operations may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

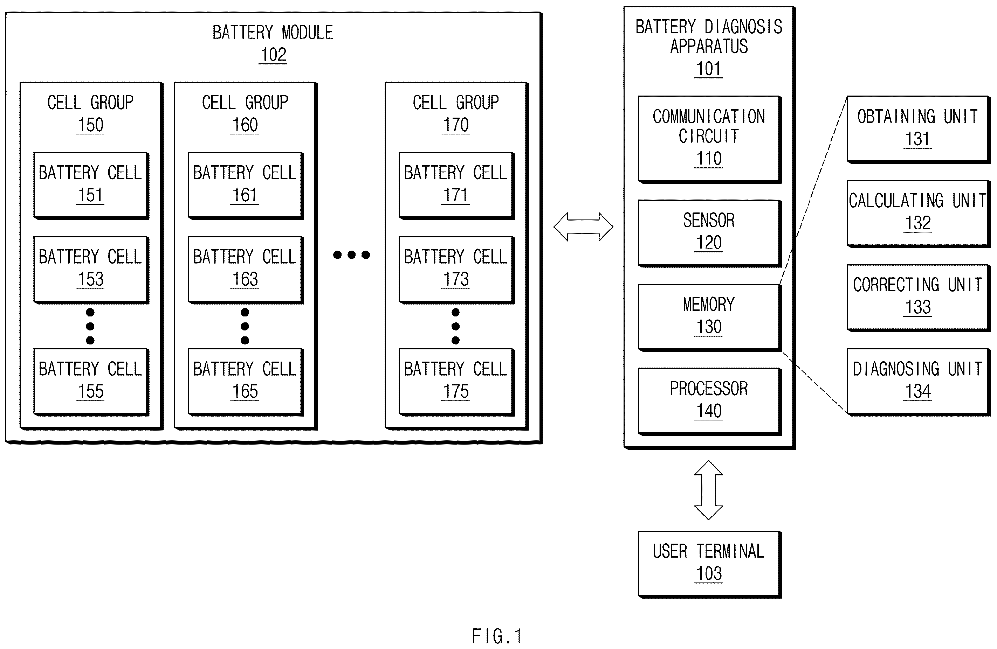

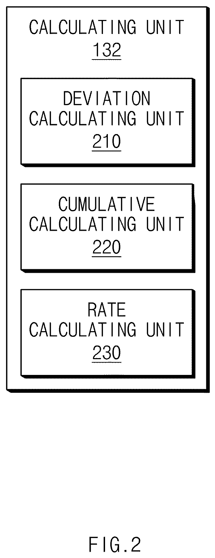

Hereinbelow, referring to FIGS. 1 and 2, components of the battery diagnosis apparatus will be described.

FIG. 1 is a block diagram of a battery diagnosis apparatus according to an embodiment. FIG. 2 is a block diagram of a calculating unit in a battery diagnosis apparatus according to an embodiment.

The battery diagnosis apparatus 101 described below may be implemented as a battery management system (BMS) in an electronic device including a battery module 102, and may also be implemented with various external devices such as a server, a cloud, a charger, a charger/discharger, etc.

Referring to FIG. 1, the battery diagnosis apparatus 101 may include a communication circuit 110, a sensor 120, a memory 130, and a processor 140. According to an embodiment, the battery diagnosis apparatus 101 shown in FIG. 1 may further include at least one component (e.g., a display, an input device, or an output device) in addition to the components shown in FIG. 1, or at least one component (e.g., the sensor 120) among the components shown in FIG. 1 may be omitted.

According to an embodiment, the battery module 102 may include a plurality of cell groups 150, 160, and 170, each of which may include a plurality of battery cells that are connected in parallel to one another. For example, the first cell group 150 may include a plurality of battery cells 151, 153, and 155 that are connected in parallel to one another, the second cell group 160 may include a plurality of battery cells 161, 163, and 165 that are connected in parallel to each other, and the third cell group 170 may include a plurality of battery cells 171, 173, and 175 that are connected in parallel to one another.

According to an embodiment, the battery diagnosis apparatus 101 may obtain data related to states (e.g., a voltage, a current, a temperature, etc.) of the plurality of cell groups 150, 160, and 170 by using the communication circuit 110 and/or the sensor 120.

According to an embodiment, the communication circuit 110 may establish a wired communication channel and/or wireless communication channel between the battery diagnosis apparatus 101 and an electronic device including the battery module 102 and/or a user terminal 103, and transmit and receive data to and from the electronic device including the battery module 102 and/or the user terminal 103 through the established communication channel. Herein, the electronic device including the battery module 102 may include a mobile device (e.g., a mobile phone, a laptop computer, a smart phone, a smart pad), an electric vehicle (e.g., an electric vehicle (EV), a hybrid EV (HEV), a plug-in HEV (PHEV), a fuel cell EV (FCEV)), an energy storage system (ESS), or a battery swapping system (BSS).

For example, when the battery diagnosis apparatus 101 is implemented with an external device such as a server, cloud, etc., the battery diagnosis apparatus 101 may obtain data related to the states of the plurality of cell groups 150, 160, and 170 from the electronic device including the battery module 102 by using the communication circuit 110. In this case, the battery diagnosis apparatus 101 may not include the sensor 120.

According to an embodiment, the user terminal 103 may include a mobile device (e.g., a mobile phone, a laptop computer, a smart phone, a smart pad) or a personal computer (PC). According to an embodiment, the battery diagnosis apparatus 101 may transmit data related to a diagnosis result for the cell group 150, 160, or 170 to the user terminal 103 by using the communication circuit 110.

According to an embodiment, the sensor 120 may measure state values of the plurality of cell groups 150, 160, and 170. For example, when the battery diagnosis apparatus 101 is implemented with a BMS (e.g., a module BMS of the battery module 102) in the electronic device including the battery module 102, the battery diagnosis apparatus 101 may directly measure the state values of the plurality of cell groups 150, 160, and 170 by using the sensor 120.

According to an embodiment, the memory 130 may include a volatile and/or a nonvolatile memory.

According to an embodiment, the memory 130 may store data used by at least one component (e.g., the processor 140) of the battery diagnosis apparatus 110. For example, the data may include software (or an instruction related thereto), input data, or output data. In an embodiment, the instruction, when executed by the processor 140, may cause the battery diagnosis apparatus 101 to perform operations defined by the instruction.

According to an embodiment, the memory 140 may include one or more software (e.g., the obtaining unit 131, the calculating unit 132, the correcting unit 133, and the diagnosing unit 134).

According to an embodiment, the processor 140 may include a central processing unit, an application processor, a graphic processing unit, a neural processing unit (NPU), an image signal processor, a sensor hub processor, or a communication processor.

According to an embodiment, the processor 140 may execute software (e.g., the obtaining unit 131, the calculating unit 132, the correcting unit 133, and the diagnosing unit 134) to control at least one other component (e.g., a hardware or software component) of the battery diagnosis apparatus 101 connected to the processor 140 and perform various data processing or operations.

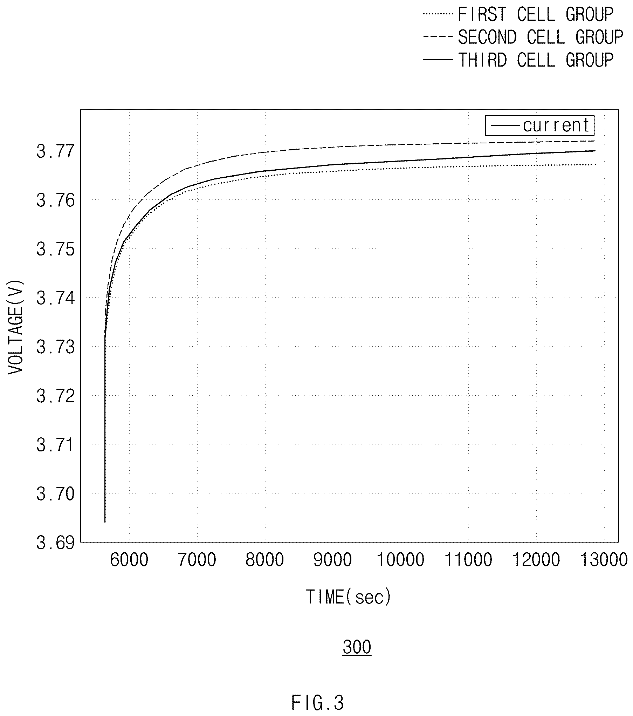

Hereinbelow, with reference to FIGS. 3 to 6, a description will be made of a method, performed by the battery diagnosis apparatus 101, of diagnosing abnormality of the cell group 150, 160, or 170 through the obtaining unit 131, the calculating unit 132, the correcting unit 133, and/or the diagnosing unit 134.

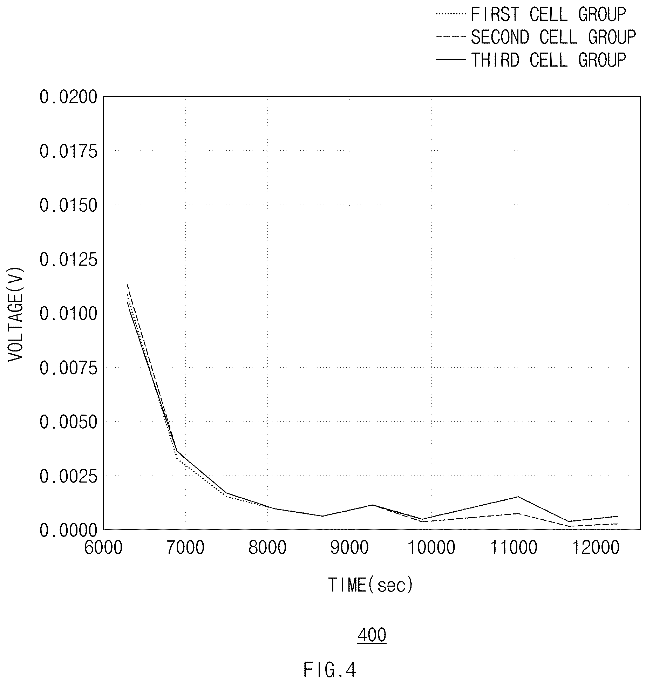

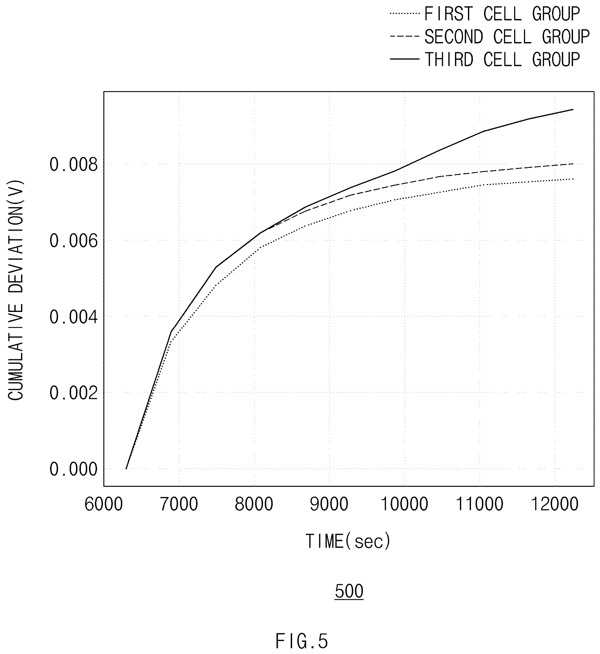

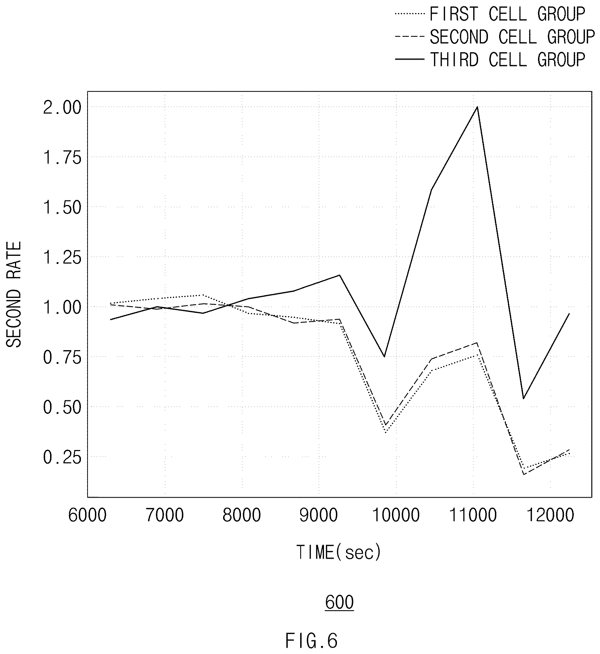

FIG. 3 shows a rest period voltage obtained by a battery diagnosis apparatus according to an embodiment. FIG. 4 shows a voltage deviation calculated by a battery diagnosis apparatus according to an embodiment. FIG. 5 shows an accumulative deviation calculated by a battery diagnosis apparatus according to an embodiment. FIG. 6 shows a second rate calculated by a battery diagnosis apparatus according to an embodiment.

According to an embodiment, the obtaining unit 131 may obtain rest period voltage data of the plurality of cell groups 150, 160, and 170 by using the communication circuit 110 and/or the sensor 120. Herein, the rest period may refer to a rest period after charging or a rest period after discharging of the plurality of cell groups 150, 160, and 170. For example, the obtaining unit 131 may obtain rest period voltage data of the first cell group 150, the second cell group 160, and the third cell group 170 as in a graph 300 of FIG. 3.

According to an embodiment, a deviation calculating unit 210 included in the calculating unit 132 may calculate a voltage deviation at designated time intervals from a point in time designated in the unit of the cell group 150, 160, or 170 based on voltage data obtained by the obtaining unit 131. Herein, the voltage deviation may refer to a voltage deviation between adjacent periods of the cell group 150, 160, or 170. The adjacent periods may refer to, for example, a target period for voltage deviation calculation and a period immediately previous to the target period. That is, the voltage deviation may refer to a difference between a voltage of the cell group 150, 160, or 170 in the target period and a voltage of the cell group 150, 160, or 170 in the immediately previous period preceding the target period by the designated time.

For example, the deviation calculating unit 210 may calculate a voltage deviation between adjacent periods of the first cell group 150, the second cell group 160, and the third cell group 170 as in a graph 400 of FIG. 4 at intervals of 200 seconds from an elapse of 600 seconds after entering the rest period based on the rest period voltage data as in the graph 300 of FIG. 3.

According to an embodiment, a cumulative calculating unit 220 included in the calculating unit 132 may accumulatively sum the voltage deviation calculated by the deviation calculating unit 210 in the unit of the cell group 150, 160, or 170 to calculate a cumulative deviation.

According to an embodiment, the cumulative calculating unit 220 may calculate a cumulative deviation corresponding to each of the first cell group 150, the second cell group 160, and the third cell group 170 based on the voltage deviation data as in the graph 400 of FIG. 4, as in the graph 500 of FIG. 5.

According to an embodiment, the cumulative calculating unit 220 may calculate a cumulative deviation by cumulatively summing the voltage deviation in the unit of each cell group 150, 160, or 170 only in a period in which a maximum voltage deviation among a plurality voltage deviations of the plurality of cell groups 150, 160, and 170, calculated by the deviation calculating unit 210 is greater than or equal to a first threshold value (e.g., 0.5 mV).

For example, when a maximum voltage deviation among a plurality of voltage deviations in a calculation target period of the plurality of cell groups 150, 160, and 170 is greater than or equal to the first threshold value, the cumulative calculating unit 220 may calculate the cumulative deviation by cumulatively summing a voltage deviation in the target period in the unit of each cell group 150, 160, or 170. That is, in this case, the cumulative deviation in the target period may be a value updated by summing the voltage deviation in the target period to a cumulative deviation in an immediately previous period.

In another example, when a maximum voltage deviation among the plurality of voltage deviations in the calculation target period of the plurality of cell groups 150, 160, and 170 is less than the first threshold value, the cumulative calculating unit 220 may exclude the voltage deviation in the target period from a cumulative summation target. That is, in this case, the cumulative deviation in the target period may be the same as the cumulative deviation in the immediately previous period.

According to an embodiment, the first threshold value may be related to a noise level occurring in voltage measurement. That is, when a voltage measurement noise level is a period of at least a threshold level, the cumulative calculating unit 220 may improve diagnosis accuracy by avoiding cumulatively adding the voltage deviation to the cumulative deviation.

According to an embodiment, the cumulative calculating unit 220 may calculate the cumulative deviation by cumulatively summing the voltage deviation in the unit of each cell group 150, 160, or 170 only for a period in which an average of the plurality of cumulative deviations of the plurality of cell groups 150, 160, and 170 is less than a second threshold value (e.g., 1 mV). Herein, the second threshold value may be a value set to prevent the cumulative deviation from continuously increasing without a limitation.

For example, for a target period in which the average value of the plurality of cumulative deviations calculated up to the immediately previous period is greater than or equal to the second threshold value, the cumulative calculating unit 220 may not sum the voltage deviation any longer and calculate the cumulative deviation calculated up to the immediately previous period as a final cumulative deviation corresponding to the corresponding period. In addition, the cumulative calculating unit 220 may cumulatively sum the voltage deviation from the target period up to a period immediately previous to another period in which the average is greater than or equal to the second threshold value, thereby calculating the final cumulative deviation corresponding to the next period.

According to an embodiment, a rate calculating unit 230 included in the calculating unit 132 may calculate a first rate in the unit of each cell group 150, 160, or 170 by using the cumulative deviation calculated by the cumulative calculating unit 220. Herein, the first rate may be a value obtained by dividing the cumulative deviation of the cell group 150, 160, or 170 by a value greater between the average of the plurality of cumulative deviations of the plurality of cell groups 150, 160, and 170 and the second threshold value.

According to an embodiment, the correcting unit 133 may correct the first rate calculated by the rate calculating unit 230 into a second rate by using an open circuit voltage (OCV) deviation according to a state of charge (SOC) change. Herein, the OCV deviation may refer to an OCV difference of the cell group 150, 160, or 170 with respect to an SOC change (e.g., an SOC change of 1 %) in a designated SOC range in the unit of each cell group 150, 160, or 170.

A rest period voltage change of the battery may be affected by a gradient of an OCV voltage curve, such that a rest period voltage deviation of cell groups included in the same battery module may differ according to an OCV deviation. Thus, the first rate for cell group-specific diagnosis may be corrected using an OCV deviation of each cell group, thereby improving diagnosis accuracy.

According to an embodiment, the correcting unit 133 may calculate an OCV deviation rate by dividing the OCV deviation by the average of the plurality of OCV deviations of the plurality of cell groups 150, 160, and 170 in the unit of each cell group 150, 160, or 170. The correcting unit 133 may calculate the second rate by dividing the first rate calculated by the rate calculating unit 230 by a value greater between the OCV deviation rate and a designated value (e.g., 1) in the unit of each cell group 150, 160, or 170.

For example, the correcting unit 133 may calculate the second rates of the first cell group 150, the second cell group 160, and the third cell group 170 as in a graph 600 of FIG. 6.

According to an embodiment, the diagnosing unit 134 may diagnose abnormality of the cell group 150, 160, or 170 based on at least one of the voltage deviation calculated by the deviation calculating unit 210, the cumulative deviation calculated by the cumulative calculating unit 220, the first rate calculated by the rate calculating unit 230, or the second rate corrected by the correcting unit 133.

According to an embodiment, the diagnosing unit 134 may diagnose, as abnormal battery cells, battery cells included in the cell group 150, 160, or 170, which satisfy designated conditions among the plurality of cell groups 150, 160, and 170.

According to an embodiment, the designated conditions may include a first condition in which a difference between the voltage deviation calculated by the deviation calculating unit 210 in a diagnosis period and an average of the plurality of voltage deviations of the plurality of cell groups 150, 160, and 170, calculated by the deviation calculating unit 210 in the diagnosis period, is less than or equal to a third threshold value (e.g., 10 mV).

According to an embodiment, the designated conditions may include a second condition in which the second rate corrected by the correcting unit 133 in the diagnosis period is a maximum value among a plurality of second rates of the plurality of cell groups 150, 160, and 170, corrected by the correcting unit 133 in the diagnosis period.

According to an embodiment, the designated conditions may include a third condition in which the second rate corrected by the correcting unit 133 in the diagnosis period is greater than or equal to a fourth threshold value (e.g., 1.5).

According to an embodiment, the designated conditions may include a fourth condition in which the second rate corrected by the correcting unit 133 in the diagnosis period is a maximum value among the plurality of second rates of the plurality of cell groups 150, 160, and 170, corrected by the correcting unit 133 in the diagnosis period and a difference between the second rate and the second maximum value among the plurality of second rates in the diagnosis period is greater than or equal to a fifth threshold value (e.g., 0.5).

According to an embodiment, the diagnosing unit 134 may diagnose, as abnormal battery cells, battery cells included in the cell group 150, 160, or 170, which satisfy any condition included in designated conditions. According to another embodiment, the diagnosing unit 134 may diagnose, as abnormal battery cells, battery cells included in the cell group 150, 160, or 170 among the plurality of cell groups 150, 160, and 170, which satisfy a designated number of conditions among at least one condition included in the designated conditions.

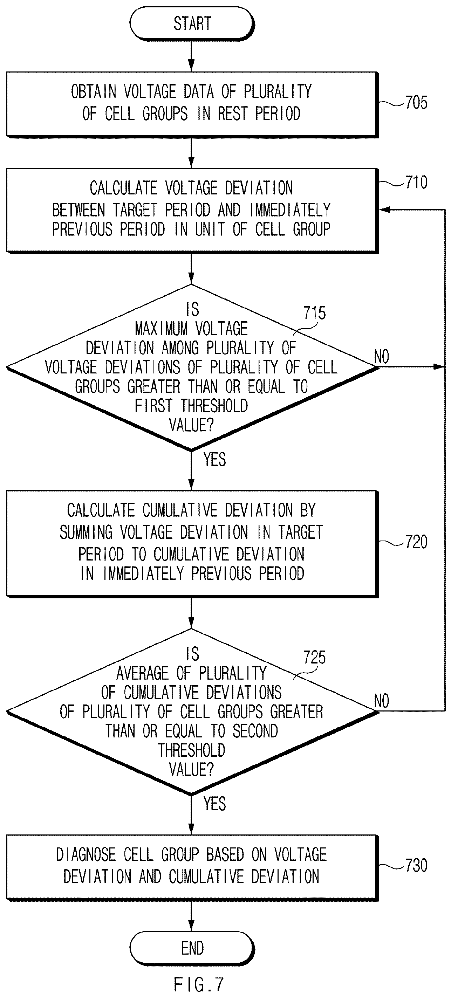

FIG. 7 is an operation flowchart of a battery diagnosis apparatus according to an embodiment. FIG. 7 is intended for a description of an operation of the battery diagnosis apparatus 101 of FIG. 1, and will be described using components of FIG. 1.

An embodiment shown in FIG. 7 is merely an embodiment, and an order of operations according to various embodiments of the present disclosure may be different from that shown in FIG. 7, some operations shown in FIG. 7 may be omitted, or an order of the operations may be changed or operations may be merged.

Referring to FIG. 7, in operation 705, the battery diagnosis apparatus 101 may obtain rest period voltage data of the plurality of cell groups 150, 160, and 170. Herein, the rest period may refer to a rest period after charging or a rest period after discharging of the plurality of cell groups 150, 160, and 170.

In operation 710, the battery diagnosis apparatus 101 may calculate a voltage deviation at designated time intervals from a designated point in time in the unit of each cell group 150, 160, or 170 based on the voltage data obtained in operation 705. Herein, the voltage deviation may refer to a voltage deviation between adjacent periods of the cell group 150, 160, or 170. The adjacent periods may refer to, for example, a target period for voltage deviation calculation and a period immediately previous to the target period. That is, the voltage deviation may refer to a difference between a voltage of the cell group 150, 160, or 170 in the target period and a voltage of the cell group 150, 160, or 170 in the immediately previous period preceding the target period by the designated time.

In operation 715, the battery diagnosis apparatus 101 may identify whether the maximum voltage deviation among the plurality of voltage deviations of the plurality of cell groups 150, 160, and 170, calculated in operation 710, is greater than or equal to the first threshold value (e.g., 0.5 mV).

When identifying that the maximum voltage deviation is less than the first threshold value ('NO') in operation 715, the battery diagnosis apparatus 101 may perform operation 710 again in the next period after an elapse of the designated time from the target period. That is, in this case, the battery diagnosis apparatus 101 may calculate a voltage deviation between the next period and the target period, in the next period.

When identifying that the maximum voltage deviation is greater than or equal to the first threshold value ('YES') in operation 715, the battery diagnosis apparatus 101 may calculate the cumulative deviation by cumulatively summing the voltage deviation, calculated in operation 710, in the unit of each cell group 150, 160, or 170, in operation 720. For example, the battery diagnosis apparatus 101 may calculate the cumulative deviation in the target period by summing the voltage deviation calculated in the target period to the cumulative deviation calculated in the immediately pervious period.

In operation 725, the battery diagnosis apparatus 101 may identify whether the average of the plurality of cumulative deviations of the plurality of cell groups 150, 160, and 170, calculated in operation 720, is greater than or equal to the second threshold value (e.g., 1 mV).

When identifying that the average is less than the second threshold value ('NO') in operation 725, the battery diagnosis apparatus 101 may perform operation 710 again in the next period after an elapse of the designated time from the target period. That is, in this case, the battery diagnosis apparatus 101 may calculate a voltage deviation between the next period and the target period, in the next period.

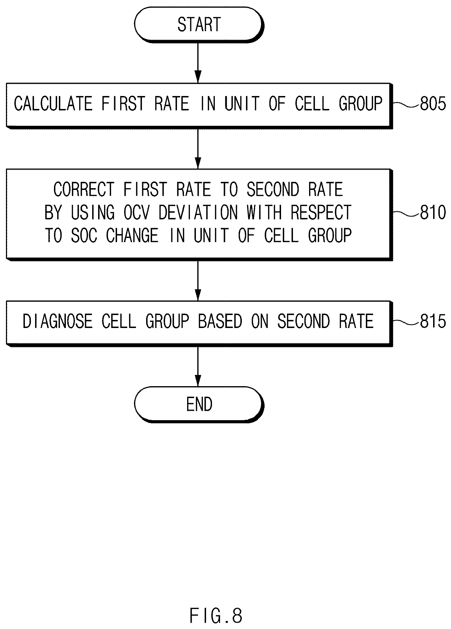

When identifying that the average is greater than or equal to the second threshold value ('YES') in operation 725, the battery diagnosis apparatus 101 may diagnose abnormality of the cell group 150, 160, or 170 based on the voltage deviation calculated in operation 710 and the cumulative deviation calculated in operation 720. According to an embodiment, the battery diagnosis apparatus 101 may diagnose abnormality of the cell group 150, 160, or 170 further based on the first rate and/or the second rate to be described below with reference to FIG. 8.

According to an embodiment, the battery diagnosis apparatus 101 may diagnose, as abnormal battery cells, battery cells included in the cell group 150, 160, or 170, which satisfy designated conditions among the plurality of cell groups 150, 160, and 170. Herein, the designated conditions may include the first to fourth conditions described above with reference to FIG. 1.

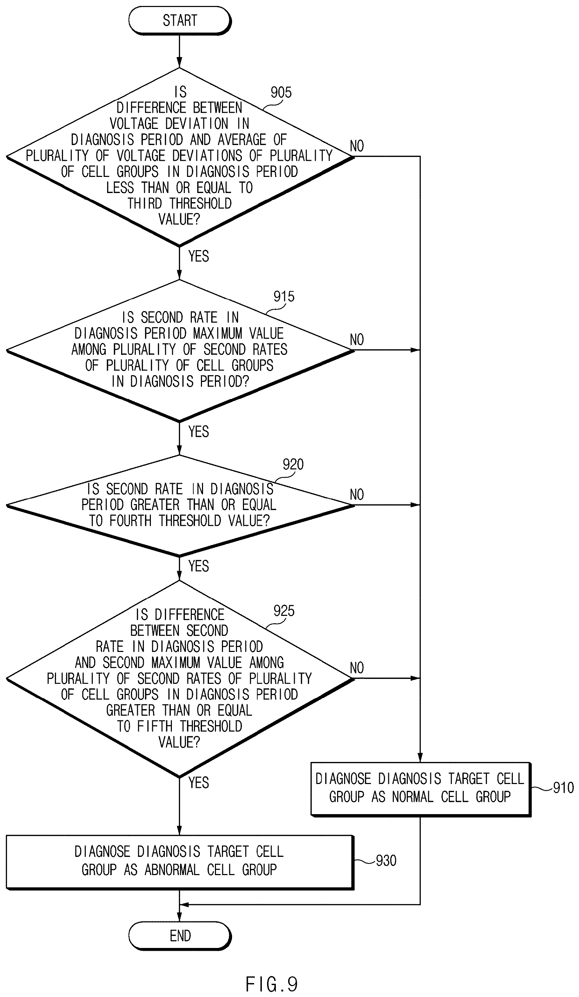

According to an embodiment, the battery diagnosis apparatus 101 may diagnose, as abnormal battery cells, battery cells included in the cell group 150, 160, or 170, which satisfy any condition included in designated conditions. The corresponding embodiment will be described in detail with reference to FIG. 9 described below.

According to another embodiment, the battery diagnosis apparatus 101 may diagnose, as abnormal battery cells, battery cells included in the cell group 150, 160, or 170 among the plurality of cell groups 150, 160, and 170, which satisfy a designated number of conditions among at least one condition included in the designated conditions.

FIG. 8 is an operation flowchart of a battery diagnosis apparatus according to an embodiment. FIG. 8 is intended for a description of an operation of the battery diagnosis apparatus 101 of FIG. 1, and will be described using components of FIG. 1.

An embodiment shown in FIG. 8 is merely an embodiment, and an order of operations according to various embodiments of the present disclosure may be different from that shown in FIG. 8, some operations shown in FIG. 8 may be omitted, or an order of the operations may be changed or operations may be merged.

Referring to FIG. 8, in operation 805, the battery diagnosis apparatus 101 may calculate the first rate in the unit of each cell group 150, 160, or 170. According to an embodiment, the battery diagnosis apparatus 101 may calculate the first rate by using the cumulative deviation calculated in operation 720 of FIG. 7. Herein, the first rate may be a value obtained by dividing the cumulative deviation of the cell group 150, 160, or 170 by a value greater between the average of the plurality of cumulative deviations of the plurality of cell groups 150, 160, and 170 and the second threshold value.

In operation 810, the battery diagnosis apparatus 101 may correct the first rate calculated in operation 805 to the second rate, by using the OCV deviation with respect to the SOC change. Herein, the OCV deviation may refer to an OCV difference of the cell group 150, 160, or 170 with respect to an SOC change (e.g., an SOC change of 1 %) in a designated SOC range in the unit of each cell group 150, 160, or 170.

A rest period voltage change of the battery may be affected by a gradient of an OCV voltage curve, such that a rest period voltage deviation of cell groups included in the same battery module may differ according to an OCV deviation. Thus, the first rate for cell group-specific diagnosis may be corrected using an OCV deviation of each cell group, thereby improving diagnosis accuracy.

According to an embodiment, the battery diagnosis apparatus 101 may calculate an OCV deviation rate by dividing the OCV deviation by the average of the plurality of OCV deviations of the plurality of cell groups 150, 160, and 170 in the unit of each cell group 150, 160, or 170. The battery diagnosis apparatus 101 may calculate the second rate by dividing the first rate calculated in operation 805 by a value greater between the OCV deviation rate and a designated value (e.g., 1) in the unit of each cell group 150, 160, or 170.

In operation 815, the battery diagnosis apparatus 101 may diagnose abnormality of the cell group 150, 160, or 170 based on the second rate corrected in operation 815.

According to an embodiment, the battery diagnosis apparatus 101 may diagnose, as abnormal battery cells, battery cells included in the cell group 150, 160, or 170, which satisfy designated conditions among the plurality of cell groups 150, 160, and 170. Herein, the designated conditions may include the first to fourth conditions described above with reference to FIG. 1.

According to an embodiment, the battery diagnosis apparatus 101 may diagnose, as abnormal battery cells, battery cells included in the cell group 150, 160, or 170, which satisfy any condition included in designated conditions. The corresponding embodiment will be described in detail with reference to FIG. 9 described below.

According to another embodiment, the battery diagnosis apparatus 101 may diagnose, as abnormal battery cells, battery cells included in the cell group 150, 160, or 170 among the plurality of cell groups 150, 160, and 170, which satisfy a designated number of conditions among at least one condition included in the designated conditions.

FIG. 9 is an operation flowchart of a battery diagnosis apparatus according to an embodiment. FIG. 9 is intended for a description of an operation of the battery diagnosis apparatus 101 of FIG. 1, and will be described using components of FIG. 1.

An embodiment shown in FIG. 9 is merely an embodiment, and an order of operations according to various embodiments of the present disclosure may be different from that shown in FIG. 9, some operations shown in FIG. 9 may be omitted, or an order of the operations may be changed or operations may be merged.

Referring to FIG. 9, in operation 905, the battery diagnosis apparatus 101 may identify whether the difference between the voltage deviation of the diagnosis target cell group 150, 160, or 170 in the diagnosis period and the average of the plurality of voltage deviations of the plurality of cell groups 150, 160, and 170 in the diagnosis period is less than or equal to the third threshold value (e.g., 10 mV).

When identifying that the difference exceeds the third threshold value ('NO') in operation 905, the battery diagnosis apparatus 101 may diagnose the diagnosis target cell group 150, 160, or 170 as a normal cell group in operation 910.

When identifying that the difference is less than or equal to the third threshold value ('YES') in operation 905, the battery diagnosis apparatus 101 may identify whether the second rate of the diagnosis target cell group 150, 160, or 170 in the diagnosis period is the maximum value among the plurality of second rates of the plurality of cell groups 150, 160, and 170 in the diagnosis period, in operation 915.

When identifying that the second rate of the diagnosis target cell group 150, 160, or 170 in the diagnosis period is not the maximum value ('NO') in operation 915, the battery diagnosis apparatus 101 may diagnose the diagnosis target cell group 150, 160, or 170 as a normal cell group in operation 910.

When identifying that the second rate of the diagnosis target cell group 150, 160, or 170 in the diagnosis period is the maximum value ('YES') in operation 915, the battery diagnosis apparatus 101 may identify whether the second rate of the diagnosis target cell group 150, 160, or 170 in the diagnosis period is greater than or equal to the fourth threshold value (e.g., 1.5) in operation 920.

When identifying that the second rate of the diagnosis target cell group 150, 160, or 170 in the diagnosis period is less than the fourth threshold value ('NO') in operation 920, the battery diagnosis apparatus 101 may diagnose the diagnosis target cell group 150, 160, or 170 as a normal cell group in operation 910.

When identifying that the second rate of the diagnosis target cell group 150, 160, or 170 is greater than or equal to the fourth threshold value ('YES') in operation 920, the battery diagnosis apparatus 101 may identify whether the difference between the second rate of the diagnosis target cell group 150, 160, or 170 in the diagnosis period and the second maximum value of the plurality of second rates of the plurality of cell groups 150, 160, and 170 in the diagnosis period is greater than or equal to the fifth threshold value (e.g., 0.5) in operation 925.

When identifying that the difference is less than the fifth threshold value ('NO') in operation 925, the battery diagnosis apparatus 101 may diagnose the diagnosis target cell group 150, 160, or 170 as a normal cell group in operation 910.

When identifying that the difference is greater than or equal to the fifth threshold value ('YES') in operation 925, the battery diagnosis apparatus 101 may diagnose the diagnosis target cell group 150, 160, or 170 as an abnormal cell group in operation 930. In this case, the battery diagnosis apparatus 101 may diagnose, as abnormal battery cells, battery cells included in the diagnosis target cell group 150, 160, or 170 diagnosed as an abnormal cell group.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

## Claims

1. A battery diagnosis apparatus comprising:
an obtaining unit configured to obtain voltage data in a rest period of a plurality of battery cells included in a battery module;
a deviation calculating unit configured to calculate a voltage deviation between adjacent periods at designated time intervals from a designated point in time, in the unit of cell groups connected in parallel to each other among the plurality of battery cells, based on the voltage data;
a cumulative calculating unit configured to calculate a cumulative deviation by cumulatively summing the voltage deviation in the unit of cell group, when a maximum voltage deviation among a plurality of voltage deviations of a plurality of cell groups in a target period is greater than or equal to a first threshold value; and
a diagnosing unit configured to diagnose, as abnormal battery cells, battery cells included in a cell group which satisfies designated conditions among the plurality of cell groups, based on the voltage deviation and the cumulative deviation.

2. The battery diagnosis apparatus of claim 1, wherein the cumulative calculating unit is further configured to calculate the cumulative deviation by cumulatively summing the voltage deviation for a period in which an average of a plurality of cumulative deviations of the plurality of cell groups is less than a second threshold value.

3. The battery diagnosis apparatus of claim 2, further comprising a rate calculating unit configured to calculate a first rate by dividing the cumulative deviation by a value greater between the average of the plurality of cumulative deviations and the second threshold value,
wherein the diagnosing unit is further configured to diagnose, abnormal battery cells, battery cells included in a cell group which satisfies the designated conditions based on the first rate.

4. The battery diagnosis apparatus of claim 3, further comprising a correcting unit configured to correct the first rate to a second rate by using an open circuit voltage (OCV) deviation with respect to a state of charge (SOC) change, in the unit of the cell group,
wherein the diagnosing unit is further configured to diagnose, abnormal battery cells, battery cells included in a cell group which satisfies the designated conditions based on the second rate.

5. The battery diagnosis apparatus of claim 4, wherein the correcting unit is further configured to:
calculate an OCV deviation rate by dividing the OCV deviation by an average of a plurality of OCV deviations of the plurality of cell groups, in the unit of the cell group; and
calculate the second rate by dividing the first rate by a value greater between the OCV deviation rate and a designated value, in the unit of the cell group.

6. The battery diagnosis apparatus of claim 4, wherein the designated conditions comprise a first condition in which a difference between the voltage deviation in a diagnosis period and an average of a plurality of voltage deviations of the plurality of cell groups in the diagnosis period is less than or equal to a third threshold value.

7. The battery diagnosis apparatus of claim 4, wherein the designated conditions comprise a second condition in which the second rate in a diagnosis period is a maximum value of a plurality of second rates of the plurality of cell groups in the diagnosis period.

8. The battery diagnosis apparatus of claim 4, wherein the designated conditions comprise a third condition in which the second rate in the diagnosis period is greater than or equal to a fourth threshold value.

9. The battery diagnosis apparatus of claim 4, wherein the designated conditions comprise a fourth condition in which the second rate in the diagnosis period is a maximum value among the plurality of second rates of the plurality of cell groups in the diagnosis period and a difference between the second rate in the diagnosis period and a second maximum value among the plurality of second rates is greater than or equal to a fifth threshold value.

10. A battery diagnosis method comprising:
obtaining voltage data in a rest period of a plurality of battery cells included in a battery module;
calculating a voltage deviation between adjacent periods at designated time intervals from a designated point in time, in the unit of cell groups connected in parallel to each other among the plurality of battery cells, based on the voltage data;
calculating a cumulative deviation by cumulatively summing the voltage deviation in the unit of cell group, when a maximum voltage deviation among a plurality of voltage deviations of a plurality of cell groups in a target period is greater than or equal to a first threshold value; and
diagnosing, as abnormal battery cells, battery cells included in a cell group which satisfies designated conditions among the plurality of cell groups, based on the voltage deviation and the cumulative deviation.

11. The battery diagnosis method of claim 10, wherein the calculating of the cumulative deviation comprises calculating the cumulative deviation by cumulatively summing the voltage deviation for a period in which an average of a plurality of cumulative deviations of the plurality of cell groups is less than a second threshold value.

12. The battery diagnosis method of claim 11, further comprising calculating a first rate by dividing the cumulative deviation by a value greater between the average of the plurality of cumulative deviations and the second threshold value,
wherein the diagnosing comprises diagnosing, abnormal battery cells, battery cells included in a cell group which satisfies the designated conditions based on the first rate.

13. The battery diagnosis method of claim 12, further comprising correcting the first rate to a second rate by using an open circuit voltage (OCV) deviation with respect to a state of charge (SOC) change, in the unit of the cell group,
wherein the diagnosing comprises diagnosing, abnormal battery cells, battery cells included in a cell group which satisfies the designated conditions based on the second rate.

14. The battery diagnosis method of claim 13, further comprising calculating an OCV deviation rate by dividing the OCV deviation by an average of a plurality of OCV deviations of the plurality of cell groups, in the unit of the cell group,
wherein the correcting of the first rate to the second rate comprises calculating the second rate by dividing the first rate by a value greater between the OCV deviation rate and a designated value in the unit of the cell group.

15. The battery diagnosis method of claim 13, wherein the designated conditions comprise:
a first condition in which a difference between the voltage deviation in a diagnosis period and an average of a plurality of voltage deviations of the plurality of cell groups in the diagnosis period is less than or equal to a threshold value;
a second condition in which the second rate in a diagnosis period is a maximum value of a plurality of second rates of the plurality of cell groups in the diagnosis period;
a third condition in which the second rate in the diagnosis period is greater than or equal to a fourth threshold value; or
a fourth condition in which the second rate in the diagnosis period is a maximum value among the plurality of second rates of the plurality of cell groups in the diagnosis period and a difference between the second rate in the diagnosis period and a second maximum value among the plurality of second rates is greater than or equal to a fifth threshold value.
